# EUROPÄISCHE PATENTSCHRIFT

(11) **EP 3 540 379 B1**
(45) Veröffentlichungstag und Bekanntmachung des Hinweises auf die Patenterteilung: **05.04.2023**
(21) Anmeldenummer: 19156825.2
(22) Anmeldetag: 13.02.2019
(51) Int. Cl.: G01D 9/00

(54) **DATENLOGGER IN KOMPAKTBAUWEISE**
DATA LOGGER HAVING A COMPACT DESIGN
ENREGISTREUR DE DONNÉES DE FORME COMPACTE

(30) Priorität: 13.03.2018 CH 3202018
(43) Veröffentlichungstag der Anmeldung: 18.09.2019
(73) Patentinhaber: Elpro-Buchs AG, 9470 Buchs (CH)
(72) Erfinder: Rudolf, Beat, 7241 Conters (CH); Neumann, Dirk, 7310 Bad Ragaz (CH)
(74) Vertreter: Bohest AG Branch Ostschweiz

(56) Entgegenhaltungen:
- DE-A1-102007 036 485
- DE-B3-102015 217 572
- US-A1- 2003 153 987
- US-A1- 2007 177 359
- US-A1- 2011 170 249
- US-A1- 2017 093 053

## Beschreibung

Die Erfindung betrifft einen Datenlogger in Kompaktbauweise gemäss dem Oberbegriff des Patentanspruchs 1.

Datenlogger werden in der Regel überall dort eingesetzt, wo eine Langzeitaufnahme von Messparametern vorgenommen werden soll, ohne dass ständig Überwachungspersonal vor Ort anwesend ist. So werden Datenlogger vor allem bei Feldversuchen, bei der Überwachung von Transporten, z. B. bei der Überwachung von Beschleunigungs-, Vibrations- und Klimawerten bei LKW- oder Bahntransporten, zur Aufzeichnung von Feuchte- und Temperaturwerten beim Transport und in Lagerhäusern, in der Pharma- und Lebensmittelindustrie, zur Fehleranalyse von Systemen, beispielsweise zur Erfassung von Spannungsschwankungen in oder an einem System, zur Überwachung und Alarmierung bei Produktionsprozessen und bei Qualitätsstudien, in Forschung, Entwicklung und in der Ausbildung verwendet. Auch im Hobbybereich, beispielsweise bei Modellflugzeugen, kommen Datenlogger zur Aufzeichnung und Überwachung von Messdaten zum Einsatz. Es sind auch Datenlogger bekannt, bei denen keine Aufzeichnung der Messwerte erfolgt. Derartige Geräte werden vielfach auch als Indikatoren bezeichnet, da ihre Aufgabe in erster Linie in der Anzeige von Verletzungen von Grenzwerten der überwachten Messgrösse bestehen. Wegen der grossen Ähnlichkeit zu den Geräten mit Messwertspeicherung werden Indikatoren in der folgenden Anmeldung jedoch nicht separat angeführt, sondern sie sind von der Sammelbezeichnung Datenlogger mit umfasst.

Die über einen längeren Zeitraum erfassten und abgespeicherten Messdaten können bei Bedarf weiterverarbeitet, grafisch dargestellt und zur Dokumentation statistisch ausgewertet werden. Neben den Messdaten erfassen Datenlogger vielfach auch verschiedene vordefinierte Ereignisse, wie z.B. einen Batteriewechsel, einen Bedienereingriff oder den Wechsel einer Speicherkarte, die während eines Überwachungszeitraums am Gerät stattfinden. Damit sollen derartige Datenlogger insbesondere ein wichtiges Kriterium der Pharma-, Lebensmittel- und Chemieindustrie, das gemeinhin unter der Bezeichnung Audit Trail bekannt ist, erfüllen. Die vom Datenlogger erfassten Messdaten und die Daten für den Audit Trail werden in einem internen Gerätespeicher abgelegt. Für die Auswertung aller Daten wird der Datenlogger üblicherweise per Kabel mit einer Datenverarbeitungsanlage, z.B. einem PC, verbunden, um die Daten auszulesen. Das Auslesen der Daten kann auch über ein kabelgestütztes oder auch ein kabelloses LAN oder dergleichen Verbindung erfolgen. Es sind auch bereits Datenlogger bekannt, die einen Datentransfer via WiFi-Technologie, Bluetooth oder NFC-Technologie an Smartphones oder Tabletcomputer ermöglichen. Nach dem Auslesen der Daten können diese mit einer üblicherweise gerätespezifischen Auswertesoftware bearbeitet werden, um sie in Form von Tabellen, Grafiken darzustellen und Dokumente oder Berichte zu erstellen. Diese bekannten Datenlogger weisen einen relativ komplexen Aufbau auf und erfordern entsprechende kabelgebundene oder kabellose Schnittstellen zum Auslesen bzw. zur Übertragung der Messdaten.

Einige der aus dem Stand der Technik bekannten Datenlogger sind mit einer Bildschirmanzeige ausgestattet, welche eine unmittelbare Darstellung und Anzeige von Messdaten und geräteinternen Auswertungen ermöglichen kann. Weitere bekannte Datenlogger weisen eine oder mehrere LEDs auf, mit denen der Systemzustand angezeigt werden kann. Die LEDs können in einigen der bekannten Datenlogger auch für eine Anzeige von Grenzwertüberschreitungen eines oder mehrerer überwachter Parameter eingesetzt werden. Mithilfe derartiger Datenlogger kann beispielsweise auch das Verfalldatum eines Produkts überwacht und bei Überschreitung mittels einer LED angezeigt werden.

Oft besteht der Wunsch, einen Datenlogger direkt am zu überwachenden Produkt, beispielsweise an einer Medikamentenschachtel oder dergleichen, anzubringen. Insbesondere sollen sie dabei eine möglichst geringe Bauhöhe aufweisen, damit eine hohe Packungsdichte gewährleistet bleibt. Eine derartige kompakte Bauweise zu erreichen, ist nicht trivial, da Datenlogger diverse Funktionseinheiten zur Erfassung, Digitalisierung, gegebenenfalls Speicherung und gegebenenfalls Auswertung von Messdaten und zur Übermittlung von Daten an ein externes Datenverarbeitungsgerät aufweisen. Die dafür erforderlichen elektronischen Bauteile sind üblicherweise auf einer Leiterplatte bzw. Platine angeordnet. Für den Betrieb des Datenloggers muss dieser mit einer Energiequelle, üblicherweise mit einer Batterie oder einem Akkumulator, ausgestattet sein. Die mit den elektronischen Bauteilen und Leiterbahnen versehene Leiterplatte und die Energiequelle, beispielsweise eine Knopfzellen-Batterie, sind innerhalb eines Gehäuses angeordnet, um sie vor mechanischen Beschädigungen zu schützen. Die Energiequelle ist dabei üblicherweise in einem separaten Batteriegehäuse angeordnet.

Die Anordnung aller Komponenten des Datenloggers innerhalb eines stabilen Gehäuses führt in der Regel zu einem Gerät mit relativ grosser Bauhöhe, wie beispielsweise aus der US 2017/093053 A1 oder der DE 10 2007 036485 A1 bekannt. Zudem bedingt bei den bekannten Datenloggern die Anordnung der elektronischen Bauteile und der Energiequelle, beispielsweise einer Knopfzellen-Batterie, immer noch einen nicht unerheblichen Anteil an Handarbeit, beispielsweise um die Energiequelle in ihr separates Gehäuse einzusetzen und elektrisch mit der Platine zu verbinden.

Aufgabe der vorliegenden Erfindung ist es daher, einen Datenlogger zu schaffen, der eine kompakte Bauweise aufweist und insbesondere eine geringere Bauhöhe aufweist, als die bekannten Datenlogger. Dabei soll der Aufbau des Datenloggers eine weitgehend automatisierte Montage begünstigen. Auf manuelle Bestückungs- und Kontaktierungsarbeit soll weitgehend verzichtet werden können.

Die Lösung dieser und weiterer Aufgaben besteht in einem Datenlogger, welcher die im Patentanspruch angeführten Merkmale aufweist. Weiterbildungen und/oder vorteilhafte Ausführungsvarianten der Erfindung sind Gegenstand der abhängigen Patentansprüche.

Die Erfindung schlägt einen Datenlogger mit innerhalb eines Gehäuses angeordneten Funktionseinheiten zur Erfassung, Digitalisierung, gegebenenfalls Speicherung und gegebenenfalls Auswertung von Messdaten und zur Übermittlung von Daten an ein externes Datenverarbeitungsgerät und mit einer innerhalb des Gehäuses angeordneten Energiequelle, insbesondere einer Batterie bzw. einem Akkumulator vor. Die Funktionseinheiten zur Erfassung, Digitalisierung, gegebenenfalls Speicherung und gegebenenfalls Auswertung von Messdaten und zur Übermittlung von Daten an ein externes Datenverarbeitungsgerät sind auf einer Leiterplatte angeordnet, die einen Bestandteil des Gehäuses des Datenloggers bildet. Das Gehäuse des Datenloggers bildet zugleich das Gehäuse der Energiequelle, wobei am Gehäuse wenigstens ein elektrischer Kontakt für die Energiequelle ausgebildet ist.

Die mit den Bauteilen bestückte Platine bildet somit einen wesentlichen Bestandteil des Gehäuses des Datenloggers und ist bereits in einem automatisierten SMT-Prozess hergestellt. Somit bildet die mit den elektronischen Komponenten bestückte Platine einen wesentlichen Bestandteil des Gehäuses. Zum Unterschied von den bekannten Datenloggern weist der Datenlogger gemäss der Erfindung auch kein separates Gehäuse für die Energiequelle, üblicherweise eine Knopfzellen-Batterie, auf. Vielmehr bildet das Gehäuse des Datenloggers auch gleichzeitig das Gehäuse für die Knopfzellen-Batterie. Die elektrischen Kontakte für die Knopfzellen-Batterie sind bereits in das Gehäuse integriert. Durch die erfindungsgemässe Gestaltung kann die Bauhöhe des Datenloggers weiter reduziert werden. Gleichzeitig verringert sich die Anzahl der Komponenten des Datenloggers, beispielsweise entfällt das separate Batteriegehäuse. Die elektrischen Kontakte für die Energiequelle sind bereits integral am Gehäuse des Datenloggers ausgebildet. Dadurch entfällt das üblicherweise händische Anlöten von Kontaktblechen. Durch die spezielle Gestaltung und Anordnung der einzelnen Bauteile sind Voraussetzungen für eine automatisierte Herstellung geschaffen.

An der Leiterplatte ist wenigstens eine erste elektrischer Kontaktfläche für die Energiequelle angeordnet, während ein zweiter elektrischer Kontakt für die Energiequelle von einer der Leiterplatte zugewandten Innenseite eines Gehäusedeckels gebildet ist. Der Gehäusedeckel ist mit der Leiterplatte verbindbar. Die Verbindung kann dabei eine formschlüssige Verbindung sein oder auch einfach durch Verkleben, Verlöten oder Verpressen erfolgen. Der Datenlogger besteht im wesentlichen nur noch aus dem Gehäusedeckel, der mit elektronischen Bauteilen bestückten Leiterplatte mit dem wenigstens einen ersten elektrischen Kontakt und der Energiequelle, üblicherweise einer Knopfzellen-Batterie.

Eine besonders niedrige Bauhöhe des Datenloggers ergibt sich, wenn die Leiterplatte mit einer Aussparung versehen ist, in die ein Aufnahmeteil für die Energiequelle eingesetzt ist, welches den wenigstens einen ersten elektrischen Kontakt für die Energiequelle aufweist. Das Aufnahmeteil besitzt eine Aussenseite, die bündig in eine Rückseite der Leiterplatte übergeht und mit dieser fluchtet. Durch die gewählte Bauweise wird der erste elektrische Kontakt nicht auf die Leiterplatte aufgesetzt, sondern ist vielmehr in diese hinein versenkt. Dadurch reduziert sich die Bauhöhe des Datenloggers um beinahe die gesamte Dicke der Leiterplatte. In einer Ausführungsvariante des Datenloggers kann die Aussparung in der Leiterplatte als ein flächiger Ausschnitt ausgebildet sein. Das Aufnahmeteil ist in die Aussparung eingesetzt und verbindet die beiden daraus resultierende flache Fortsätze der Leiterplatte und stützt sich an diesen ab.

Um eine gute Halterung der zwischen dem in die Leiterplatte eingesetzten Aufnahmeteil und dem Gehäusedeckel gehaltenen Energiequelle, insbesondere einer Knopfzellen-Batterie zu gewährleisten, ist eine von den flachen Fortsätzen eingeschlossene Stirnfläche des Ausschnitts in der Leiterplatte als eine Anlagefläche für die Knopfzellen- Batterie ausbildet. Die Stirnfläche weist dazu wenigstens bereichsweise eine korrespondierend zur Umfangsgeometrie der Knopfzellen-Batterie gekrümmte Kontur auf.

In einer zweckmässigen und wirtschaftlich herstellbaren Ausführungsvariante der Erfindung sind der Gehäusedeckel und das Aufnahmeteil jeweils als ein Stanzbiegeteil aus einem elektrisch leitenden Metallblech ausgebildet.

Der erfindungsgemässe Datenlogger kann für ein Auslesen über einen USB Anschluss oder auch für ein drahtloses Auslesen, wie beispielsweise über Bluetooth, ZigBee, WLAN oder NFC, ausgebildet sein. Im letzteren Fall umfassen die innerhalb des Gehäuses angeordneten Funktionseinheiten auch eine Einheit für eine drahtlose Datenübermittlung.

Eine Ausführungsvariante des Datenloggers kann vorsehen, dass die Einheit für die drahtlose Datenübermittlung mit einer elektromagnetische Strahlung emittierenden Anzeigeeinrichtung ausgestattet ist, die von aussen sichtbar am bzw. innerhalb des Gehäuses montiert ist. Die eine elektromagnetische Strahlung emittierende Anzeigeeinrichtung kann für eine Emission von Licht im sichtbaren Wellenlängenspektrum von ca. 380 nm bis ca. 780 nm liegen, oder es kann sich dabei um Infrarotstrahlung von ca. 780 nm bis 1µm handeln. Es sind auch kombinierte Emissionen von sichtbarer Strahlung und Infrarotstrahlung möglich.

In einer weiteren Ausführungsvariante des Datenloggers umfasst die eine elektromagnetische Strahlung emittierende Anzeigeeinrichtung wenigstens eine Leuchtdiode, die vorzugsweise an der Leiterplatte angeordnet ist. Die wenigstens eine Leuchtdiode kann an einer Stirnseite der Leiterplatte angeordnet sein. Der Datenlogger weist dann an der entsprechenden Position an der Schmalseite des Gehäuses eine Öffnung oder Aussparung auf, durch die die Leuchtdiode ihre Strahlung abgeben kann. Bei einer weiteren Ausführungsvariante der Erfindung ist die wenigstens eine Leuchtdiode auf der Leiterplatte angeordnet. In einer Deckfläche des Gehäusedeckels ist dann an einer Position, die zur Anordnung der wenigstens einen Leuchtdiode an der Leiterplatte korrespondiert, ein Fenster ausgespart. Die Leuchtdiode kann beispielsweise für eine mehrfarbige Anzeige ausgebildet sein. Das Fenster kann beispielsweise durch Stanzen im Gehäusedeckel ausgebildet sein. Bei einer Ausführungsvariante des Datenloggers mit mehreren Leuchtdioden kann am Gehäusedeckel eine Anzahl von korrespondierenden Fenstern ausgebildet sein, die der Zahl von Leuchtdioden an der Leiterplatte entspricht. In einer alternativen Ausführungsvariante können unterhalb eines Fensters im Gehäusedeckel auch mehrere Leuchtdioden dicht nebeneinander angeordnet sein. Bei einer Ausführungsvariante des Datenloggers kann dieser eine Leuchtdiode aufweisen, die sowohl für eine Anzeige des Betriebszustands als auch für eine Datenübertragung vorgesehen ist. Eine weitere Ausführungsvariante des Datenloggers kann vorsehen, dass neben wenigstens einer Leuchtdiode für die Anzeige des Betriebszustands wenigstens eine weitere Leuchtdiode vorgesehen ist, die nur zur Datenübertragung dient. Die wenigstens eine zusätzliche Leuchtdiode kann hinsichtlich ihrer Funktion der Datenübertragung optimiert sein. Auf diese Weise die Datenübertragungsrate erhöht und optimiert werden.

Bei einem weiteren Ausführungsbeispiel des Datenloggers kann in der Deckfläche des Gehäusedeckels auch eine bewegliche Zunge ausgebildet sein, die mit einem Betätigungstaster zusammenwirkt, der auf der Leiterplatte angeordnet ist. Je nach Ausführung des Datenloggers können über den Taster verschiedene Modi des Datenloggers, beispielsweise Ein/Aus, Messmodus, Übermittlungsmodus, angewählt werden.

Bei einer Ausführungsvariante des Datenloggers ist die Funktionseinheit zur Datenübermittlung für eine zeitlich und/oder intensitätsgesteuerte Modulation der elektromagnetische Strahlung emittierenden Anzeigeeinrichtung ausgebildet. Bei den Daten kann es sich um gemessene Rohdaten und/oder auch um Ergebnisse der bereits ausgewerteten Messdaten handeln. Es können vollständige Datensätze übertragen werden oder auch nur Auszüge aus den Daten. Die kodiert übermittelten Daten können unmittelbar von einem externen Datenverarbeitungsgerät erfasst und aufgezeichnet werden, indem dessen fototechnische Erfassungseinrichtung die von der elektromagnetische Strahlung emittierenden Anzeigeeinrichtung erzeugten statischen und/oder dynamischen Lichtmuster registriert und in einer Speichereinheit des Datenverarbeitungsgeräts für eine Weiterverarbeitung abspeichert.

Die Funktionseinheit zur Datenübermittlung kann für eine zeitlich und/oder intensitätsgesteuerte Modulation der elektromagnetische Strahlung emittierenden Anzeigeeinrichtung ausgebildet sein. Dabei kann es sich um eine digitale Phasenmodulation handeln, die beispielsweise nach einem ein- oder mehrdimensionalen Manchester Code durchführbar ist. Der Manchester Code wird dabei dazu benützt, um Daten und Taktrate gleichzeitig zu übertragen. Die Übertragung der Taktrate ist erforderlich, da die fototechnischen Erfassungseinrichtungen am tragbaren Datenverarbeitungsgerät in der Regel asynchron zum Takt der elektromagnetische Strahlung emittierenden Anzeigeeinrichtung, insbesondere der von den Leuchtdioden gelieferten statischen und/oder dynamischen Lichtmuster betrieben werden. In Sinne der Erfindung wird unter der Bezeichnung Manchester Code auch das Protokoll eines differentiellen Manchester Codes verstanden. Ein mehrdimensionaler Manchester Code wird eingesetzt, wenn die Datenübermittlung beispielsweise über mehrere parallel betreibbare Leuchtdioden oder dergleichen Anzeigeeinrichtungen erfolgt, wobei über alle Leuchtdioden hinweg immer nur mindestens eine Leuchtdiode ihren Zustand von einem Helligkeitswert zum nächsten ändert. Die Modulation kann dabei digital über eine Aktivierung oder Deaktivierung der jeweiligen Leuchtdiode erfolgen. In einer weiteren Ausführungsvariante der Erfindung können die Leuchtdioden auch mit abgestuften Helligkeiten betrieben werden.

Die Datenübermittlung per elektromagnetischer Strahlung erfolgt an ein externes Datenverarbeitungsgerät. Dabei kann es sich um ein stationäres Gerät oder um ein tragbares Gerät handeln. In einer Ausführungsvariante des Datenloggers kann die von der Funktionseinheit zur Datenübermittlung angesteuerte elektromagnetische Strahlung, insbesondere Licht und/oder Infrarotstrahlung emittierende Anzeigeeinrichtung für eine, vorzugsweise visuelle, unidirektionalen Kommunikation mit einem Smartphone, einem Notebook oder einem Tabletcomputer ausgebildet sein. Das Smartphone, der Notebook bzw. der Tabletcomputer weisen eine Kamera zur visuellen Aufnahme von statischen und/oder dynamischen Lichtmustern auf. Zur Erfassung und zur Bearbeitung der übermittelten Daten können sie mit einer Applikation zur Dekodierung und Weiterverarbeitung der von der lichtemittierenden Anzeigeeinrichtung übermittelten Daten ausgestattet sein. Dabei kann die Funktionseinheit zur Datenübermittlung zur Übermittlung der Daten an ein Smartphone, an ein Notebook oder an einen Tabletcomputer mit beliebigem Betriebssystem ausgebildet sein. Insbesondere können das Smartphone bzw. der Tabletcomputer dabei aus der Gruppe bestehend aus Android, iOS, Windows Phone und Blackberry OS aufweisen.

Smartphones, Notebooks und Tabletcomputer sind mittlerweile weit verbreitet. Sie sind und werden mit immer hochwertigeren Kameras ausgestattet, sodass eine Erfassung der über die elektromagnetische Strahlung, insbesondere sichtbares Licht bzw. Infrarotstrahlung emittierende Anzeigeeinrichtung, beispielsweise die Leuchtdioden, übermittelten Daten sehr schnell und zuverlässig vonstatten gehen kann. Die Erfassung und Aufzeichnung der übermittelten Daten erfolgt unabhängig vom Typ des Smartphones, Notebooks bzw. des Tabletcomputers und dessen Betriebssystem.

Die von der Funktionseinheit zur Datenübermittlung angesteuerte elektromagnetische emittierende Anzeigeeinrichtung kann auch für eine unidirektionalen Kommunikation mit einem eingebetteten Computersystem ausgebildet sein. Unter einem eingebetteten Computersystem ist dabei ein Datenverarbeitungsgerät zu verstehen, das zum Unterschied von Personal Computern nicht mit den üblichen Peripheriegeräten wie Tastatur, Maus oder Festplatte ausgestattet ist, sondern eine Spezialperipherie wie z.B. funktionelle Tasten, Drehschalter usw. nutzt. Ein eingebettetes Computersystem ist nur für ganz spezifische Aufgaben ausgebildet und benötigt daher nur einen minimalen Aufwand an Hard- und Software. Der Prozessor ist nur zur Erfüllung der spezifischen Aufgabe ausgebildet und kann beispielsweise ein Field Programmable Gate Array (FPGA) oder ein spezieller Application Specific Integrated Circuit (ASIC) sein. Dadurch kann die Leistungsaufnahme des eingebetteten Computersystems sehr gering gehalten werden. Ein eingebettetes Computersystem benötigt oft nicht einmal ein eigenes Betriebssystem bzw. kommt mit speziellen reduzierten Versionen von Standard-Betriebssystemen aus. Anwendungsprogramme, die als sogenannte eingebettete Software ausgeführt werden, sind hinsichtlich ihrer Funktion optimiert und zeichnen sich durch üblicherweise durch einen sehr stabilen Ablauf aus.

Weitere Vorteile und Merkmale ergeben sich aus der nachfolgenden Beschreibung einer beispielsweisen Ausführungsvariante der Erfindung unter Bezugnahme auf die schematischen Zeichnungen. Es zeigen in nicht massstabsgetreuer Darstellung:
- Fig. 1: eine explodierte Darstellung eines Ausführungsbeispiels des erfindungsgemässen Datenloggers;
- Fig. 2: einen zusammengesetzten Datenlogger gemäss Fig. 1 mit eingesetzter Knopfzellen-Batterie;
- Fig. 3: eine perspektivische Ansicht einer Leiterplatte mit eingesetztem Aufnahmeteil für eine Knopfzellen-Batterie; und
- Fig. 4: eine perspektivische Ansicht eines Gehäusedeckels mit Blick auf ihre Innenseite.

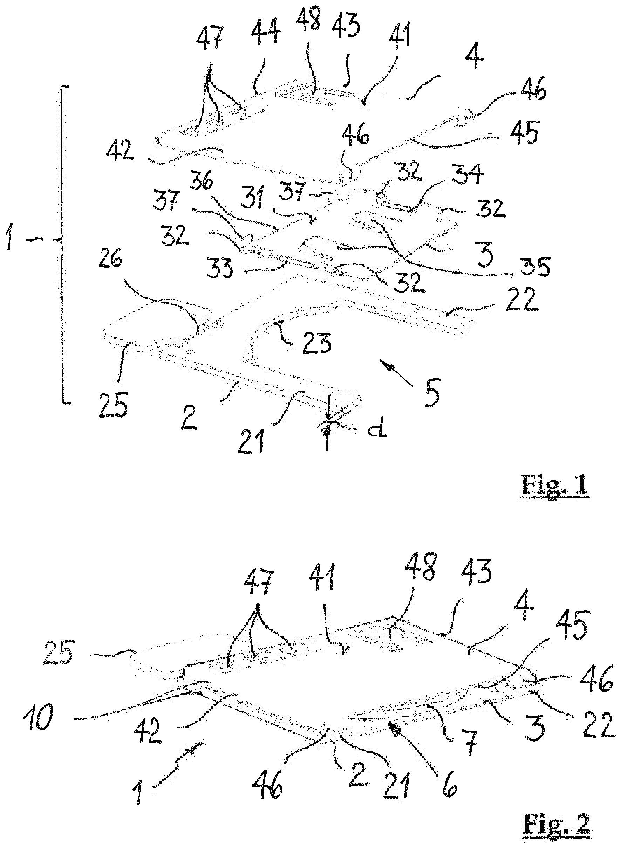

Die perspektivische explodierte Darstellung in Fig. 1 zeigt die Komponenten eines Ausführungsbeispiels eines Datenloggers, das gesamthaft das Bezugszeichen 1 trägt. Die Komponenten des Datenloggers 1 umfassen eine Leiterplatte bzw. Platine 2, ein Aufnahmeteil 3 für eine Energiequelle, beispielsweise eine Knopfzellen-Batterie, und einen Gehäusedeckel 4. Aus Gründen der besseren Übersichtlichkeit wurde auf die Darstellung der auf der Leiterplatte 2 angeordneten elektronischen Bauteile und Leiterbahnen verzichtet. Diese sind für den mechanischen Aufbau des Datenloggers auch nicht wesentlich. Ebenso wurde in Fig. 1 auf die Darstellung einer innerhalb des Datenloggers 1 angeordneten Energiequelle, üblicherweise einer Knopfzellen-Batterie, verzichtet.

Die Leiterplatte 2 bzw. Platine ist flächig ausgebildet und weist eine Bauhöhe d von ca. 0,8 m bis 1 mm auf. Eine Aussparung 5 in der Leiterplatte 2 ist von zwei flachen Fortsätzen 21, 22 der Leiterplatte 2 berandet. Eine von der Aussparung 5 resultierende Stirnfläche 23 der Leiterplatte 2 weist wenigstens bereichsweise einen kreisbogenförmig gekrümmten Verlauf auf und folgt damit der Aussenkontur einer Knopfzellen-Batterie, die üblicherweise als Energiequelle im Datenlogger 1 eingesetzt wird und einen kreisförmigen Querschnitt aufweist.

Das Aufnahmeteil 3 ist ein flächig ausgebildetes Biegestanzteil aus einem elektrisch leitfähigen Metallblech. Das flächig ausgebildete Aufnahmeteil 3 ist als Einsatz in die Aussparung 5 der Leiterplatte 2 ausgebildet. Dazu weist es vier Laschen 32 auf, die paarweise an Breitseiten 33, 34 des Aufnahmeteils 3 angeordnet sind und gegenüber einer Oberseite 31 des Aufnahmeteils erhaben ausgebildet sind und die Breitseiten 33, 34 überragen. Die Höhe der Laschen 32 gegenüber der Oberseite 31 des Aufnahmeteils 3 entspricht etwa der Bauhöhe d der Leiterplatte 2. Die Laschen 32 dienen zur Abstützung des Aufnahmeteils 3 an den flachen Fortsätzen 21, 22 der Leiterplatte 2 bei in die Aussparung 5 eingesetztem Aufnahmeteil 3 und zur Erstellung von elektrischen Verbindungen zu korrespondierenden Kontakten auf den Fortsätzen 21, 22. Am Aufnahmeteil sind beispielsweise zwei erste elektrische Kontakte 35 ausgebildet, die gegenüber der Oberseite 31 des Aufnahmeteils 3 abragen und eine gewisse Federwirkung aufweisen. Das Aufnahmeteil 3 kann an einer seiner Längsseiten 36 auch noch zwei Fortsätze 37 aufweisen, die sich etwa senkrecht gegenüber der Oberseite 31 des Aufnahmeteils 3 erstrecken. Die Fortsätze 37 weisen eine Länge 1 auf, die etwa der Bauhöhe d der Leiterplatte 2 entspricht bzw. diese geringfügig überschreitet. Die Fortsätze 37 dienen zur Abstützung des Aufnahmeteils 3 an der durch die Aussparung 5 in der Leiterplatte 2 gebildeten Stirnfläche 23.

Der Gehäusedeckel 4 ist ein Stanzbiegeteil aus einem elektrisch leitfähigen Metallblech. Der Gehäusedeckel 4 weist von einer Deckfläche 41 abgekantete Breitseiten 42, 43 und eine abgekantete Längsseite 44 auf. Eine gegenüberliegende zweite Längsseite 45 kann ebenfalls über ihre gesamte Längserstreckung abgekonnten ausgebildet sein. Alternativ können, wie beispielsweise dargestellt, an den beiden Enden der zweiten Längsseite 45 abgekantete Stege 46 ausgebildet sein. Die abgekanteten Breitseiten 42, 43, die abgekantete Längsseite 44 und die Stege 46 stützen den Gehäusedeckel 4 im zusammengebauten Zustand an der Leiterplatte 2 und an den flachen Fortsätzen 21, 22 der Leiterplatte 2 ab und erstellen elektrische Verbindungen zu korrespondierend ausgebildeten Kontakten auf der Leiterplatte 2.

Fig. 2 zeigt einen Datenlogger 1 im zusammengefügten Zustand der einzelnen Komponenten 2, 3 und 4. Es ist klar ersichtlich, dass sich der Gehäusedeckel 4 über seine abgekanteten Breitseiten 42, 43 die abgekantete Längsseite und die Stege 46 an der zweiten Längsseite 45 auf der Leiterplatte 2 bzw. auf den flachen Fortsätzen 21, 22 der Leiterplatte 2 abstützt. Die Leiterplatte 2 mit dem in die Aussparung eingesetzten Aufnahmeteil 3 und der Gehäusedeckel 4 bilden zusammen ein Gehäuse 10 des Datenloggers 1. Das in die Aussparung in der Leiterplatte 2 eingesetzte Aufnahmeteil 3 besitzt eine Aussenseite (nicht dargestellt), die bündig in eine Rückseite (nicht dargestellt) der Leiterplatte 2 übergeht und mit dieser fluchtet. Ein Einschubspalt 6 wird seitlich von den an den beiden Enden der zweiten Längsseite 45 angeordneten Stege 46, nach oben vom Gehäusedeckel 4 und nach unten vom Aufnahmeteil 3 bzw. der Leiterplatte 2 begrenzt. Der Einschubspalt 6 ermöglicht es, eine Energiequelle 7, üblicherweise eine Knopfzellen-Batterie in das Gehäuse 10 des Datenloggers 1 einzusetzen. Dabei kommt eine Unterseite der Energiequelle 7 bzw. der Knopfzellen-Batterie auf das Aufnahmeteil 3 mit den ersten elektrischen Kontakten 35 (Fig. 1) zu liegen. Durch die federnde Wirkung der elektrischen Kontakte 35 (Fig. 1) kommt eine gegenüberliegende Oberseite der Energiequelle 7 bzw. der Knopfzellen-Batterie in Anlage zur Innenseite des Gehäusedeckels 4, der gesamthaft einen zweiten elektrischen Kontakt zur Energiequelle 7 bildet.

Auf der Rückseite (nicht dargestellt) der Leiterplatte 2 kann eine Kleberschicht, beispielsweise ein Doppelklebeband angeordnet sein, mit dem der Datenlogger 1 an dem zu überwachenden Gegenstand oder an dessen Verpackung befestigbar ist.

Fig. 1 und Fig. 2 zeigen, dass in der Deckfläche 41 des Gehäusedeckels 4 mehrere Fenster 47 ausgebildet sind. Die Position der Fenster 47 korrespondiert mit der Anordnung von Leuchtdioden auf der Leiterplatte 2. Die Fenster 47 können beispielsweise durch Stanzen im Gehäusedeckel 4 erstellt sein. Aus Fig. 1 und Fig. 2 ist auch ersichtlich, dass in der Deckfläche 41 des Gehäusedeckels 4 eine bewegliche Zunge 48 ausgebildet ist. Die bewegliche Zunge 48 wirkt mit einem Betätigungstaster zusammen, der auf der Leiterplatte 2 angeordnet ist. Je nach Ausführung des Datenloggers können über den Taster verschiedene Modi des Datenloggers 1, beispielsweise Ein/Aus, Messmodus, Übermittlungsmodus, angewählt werden. Schliesslich zeigen Fig. 1 und Fig. 2 auch noch einen von der Leiterplatte 2 abragenden knebelartigen Fortsatz 25. Dieser ist über eine Sollbruchstelle 26 (Fig. 1) mit der Leiterplatte 2 verbunden. Durch Abbrechen des Fortsatzes 25 kann der Datenlogger 1 vom Anwender aktiviert und/oder gestartet werden. Durch das Abbrechen des Fortsatzes 25 wird beispielsweise eine Widerstand verändert, der vom Datenlogger 1 überwacht wird.

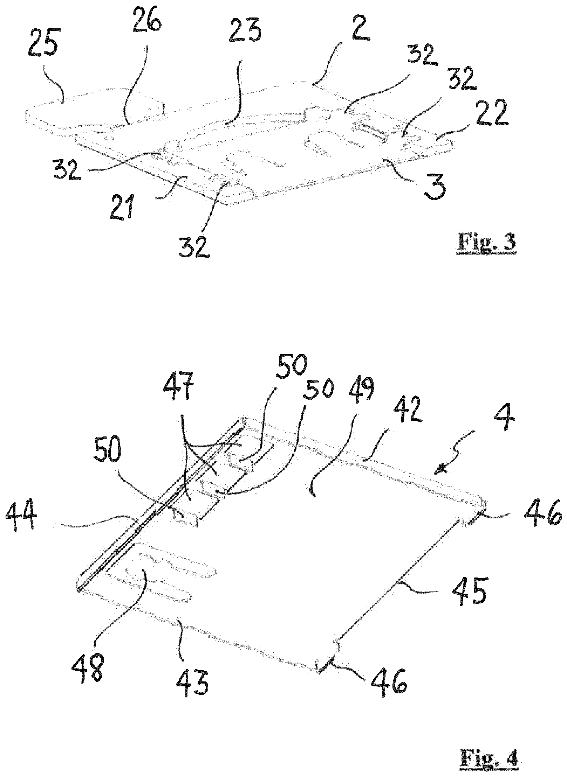

Fig. 3 zeigt eine perspektivische Darstellung der Leiterplatte 2 mit in die Aussparung 5 eingesetztem Aufnahmeteil 3. Aus der Abbildung ist die besonders flache Bauweise ersichtlich. Insbesondere weist das Aufnahmeteil 3 eine Aussenseite auf, die bündig in eine Rückseite der Leiterplatte 2 übergeht und mit dieser fluchtet (nicht dargestellt). Auch ist deutlich ersichtlich, dass sich die am Aufnahmeteil 3 ausgebildeten Laschen 32 an den flachen Fortsätzen 21, 22 der Leiterplatte 2 abstützen. Die gekrümmte Stirnfläche an der Aussparung der Leiterplatte 2 trägt wiederum das Bezugszeichen 23.

Fig. 4 zeigt eine perspektivische Ansicht des Gehäusedeckels 4 mit Blick auf dessen Innenseite 49. Die abgekanteten Breitseiten 42, 43, die abgekantete Längsseite 44 und die beiden abgekanteten Stege 46 an dessen zweiter Längsseite 45 sind deutlich sichtbar. Im Bereich der gestanzten Fenster 47 ragen Materialstege 50 von der Innenseite 49 des Gehäusedeckels 4 ab. Die Materialstege dienen zur Abstützung des Gehäusedeckels 4 auf der Leiterplatte und schirmen die dort angeordneten Leuchtdioden gegenseitig ab. Dadurch kann keine Strahlung von benachbarten Leuchtdioden durch das jeweilige Fenster 47 dringen.

Innerhalb des Gehäuses 10 des Datenloggers 1 sind die verschiedene Funktionseinheiten zur Erfassung, Digitalisierung, gegebenenfalls Speicherung und gegebenenfalls Auswertung von Messdaten sowie zur Übermittlung von Daten angeordnet. Die Funktionseinheiten können mit einem zentralen Mikroprozessor gekoppelt sein, der über die bewegliche Zunge 48 und den Taster auf der Leiterplatte aktivierbar ist und über den die verschiedenen Modi des Datenloggers 1 anwählbar sind. Alternativ können die Funktionseinheiten eigene Mikrocontroller aufweisen. Die Aktivierung der jeweiligen Funktionseinheit erfolgt dann ebenfalls über die Zunge 48 und den Taster auf der Leiterplatte.

Die Leuchtdioden auf der Leiterplatte können durch die zugeordneten Fenster 47 beispielsweise einen gerade angewählten Funktionsmodus des Datenloggers 1 anzeigen. Ihre eigentliche Funktion besteht jedoch in der visuellen Übermittlung von im Datenlogger 1 abgespeicherten Daten an ein externes, tragbares Datenverarbeitungsgerät. Bei dem externen Datenverarbeitungsgerät kann es sich beispielsweise um ein Smartphone handeln, das mit einer Kamera zur Aufnahme von statischen und bewegten Bildern ausgestattet ist. Alternativ kann das tragbare Datenverarbeitungsgerät auch ein Tabletcomputer oder auch ein Notebookcomputer sein, welche jeweils mit einer Kamera zur Aufnahme von statischen und bewegten Bildern ausgestattet sind.

Zur Datenübermittlung vom Datenlogger 1 zum externen Datenverarbeitungsgerät wird über die bewegliche Zunge 48 in der Deckfläche 41 des Gehäusedeckels 4 und den Taster auf der Leiterplatte die entsprechende Funktionseinheit des Datenloggers 1 aktiviert. Diese ist mit den Leuchtdioden auf der Leiterplatte gekoppelt und übermittelt die Daten durch eine zeitlich und/oder intensitätsmässig gesteuerte Aktivierung der Leuchtdioden in kodierter Form.

Die externe Datenverarbeitungsanlage ist mit einer Applikation ausgestattet, die unter einem oder mehreren Betriebssystemen wie z.B. Android, iOS, Windows Phone und Blackberry OS ausführbar ist. Die von der Kamera aufgezeichneten codierten Lichtpulse der Leuchtdioden des Datenloggers 1 werden von der Applikation wieder zu den übermittelten Daten dekodiert, abgespeichert und können weiterverarbeitet werden. Die Ergebnisse der Weiterverarbeitung können dann beispielsweise über einen Bildschirm der externen Datenverarbeitungsanlage, beispielsweise eines Smartphones, in Form eines Berichts ausgegeben werden. Alternativ können die Ergebnisse auch elektronisch, z.B. per E-Mail, in Berichtsform, beispielsweise als PDF-Datei, weitergeleitet werden.

Die innerhalb des Gehäuses 10 des Datenloggers 1 angeordnete Funktionseinheit zur Datenübermittlung kann für eine zeitlich und/oder helligkeitsgesteuerte Modulation der Leuchtdioden ausgebildet sein. Dabei kann es sich um eine digitale Phasenmodulation handeln, die beispielsweise nach einem ein- oder mehrdimensionalen Manchester Code durchführbar ist. Der Manchester Code wird dabei dazu benützt, um Daten und Taktrate gleichzeitig zu übertragen. Das erzeugte Signal garantiert immer Taktflanken, um sowohl die Daten als auch die Taktrate zurückzugewinnen. Die Übertragung der Taktrate ist erforderlich, da die fototechnischen Erfassungseinrichtungen am tragbaren Datenverarbeitungsgerät in der Regel asynchron zum Takt der von den Leuchtdioden gelieferten Lichtimpulse betrieben werden. In Sinne der Erfindung wird unter der Bezeichnung Manchester Code auch das Protokoll eines differentiellen Manchester Codes verstanden. Ein mehrdimensionaler Manchester Code wird eingesetzt, wenn die Datenübermittlung über mehrere parallel betreibbare Leuchtdioden oder dergleichen Anzeigeeinrichtungen erfolgt, wobei über alle Leuchtdioden hinweg immer nur mindestens eine Leuchtdiode ihren Zustand von einem Helligkeitswert zum nächsten ändert. Die Modulation kann dabei digital über eine Aktivierung oder Deaktivierung der jeweiligen Leuchtdiode erfolgen. In einer weiteren Ausführungsvariante der Erfindung können die Leuchtdioden 5 auch mit abgestuften Helligkeiten betrieben werden. Dadurch kann die Übertragungsrate erhöht werden.

Die Erfindung ist am Beispiel eines Datenloggers mit einer visuellen Übermittlung von Daten mittels mehrerer Leuchtdioden erläutert worden. Prinzipiell kann eine visuelle Datenübermittlung auch mit nur einer Leuchtdiode durchgeführt werden. Die erzielbare Übertragungsrate ist dabei jedoch noch relativ klein. Der erfindungsgemässe Datenlogger in Kompaktbauweise kann für ein Auslesen auch über einen USB Anschluss oder auch für ein drahtloses Auslesen, wie beispielsweise über Bluetooth, ZigBee, WLAN oder NFC, ausgebildet sein. Die vorstehende Beschreibung dient nur zur Erläuterung der Erfindung und ist nicht als einschränkend zu betrachten. Vielmehr wird die Erfindung durch die Patentansprüche definiert.

## Patentansprüche

1. Datenlogger mit innerhalb eines Gehäuses angeordneten Funktionseinheiten zur Erfassung, Digitalisierung, gegebenenfalls Speicherung und gegebenenfalls Auswertung von Messdaten und zur Übermittlung von Daten an ein externes Datenverarbeitungsgerät und mit einer innerhalb des Gehäuses angeordneten Energiequelle, insbesondere einer Knopfzellen-Batterie, wobei die Funktionseinheiten zur Erfassung, Digitalisierung, gegebenenfalls Speicherung und gegebenenfalls Auswertung von Messdaten und zur Übermittlung von Daten an ein externes Datenverarbeitungsgerät auf einer Leiterplatte angeordnet sind, die einen Bestandteil des Gehäuses des Datenloggers bildet, und wobei das Gehäuse des Datenloggers zugleich das Gehäuse der Energiequelle bildet und am Gehäuse wenigstens ein elektrischer Kontakte für die Energiequelle ausgebildet ist.

2. Datenlogger nach Anspruch 1, **dadurch gekennzeichnet, dass** die Leiterplatte mit wenigstens einer ersten elektrischen Kontaktfläche für die Energiequelle ausgestattet ist, während ein zweiter elektrischer Kontakt für die Energiequelle von einer der Leiterplatte zugewandten Innenseite eines Gehäusedeckels gebildet ist, der mit der Leiterplatte verbindbar ist.

3. Datenlogger nach Anspruch 2, **dadurch gekennzeichnet, dass** die Leiterplatte mit einer Aussparung versehen ist, in die ein Aufnahmeteil für die Energiequelle eingesetzt ist, welches den wenigstens einen ersten elektrischen Kontakt für die Energiequelle aufweist und eine Aussenseite besitzt, die bündig in eine Rückseite der Leiterplatte übergeht und mit dieser fluchtet.

4. Datenlogger nach Anspruch 3, **dadurch gekennzeichnet, dass** Aussparung in der Leiterplatte als ein flächiger Ausschnitt ausgebildet ist und das Aufnahmeteil zwei daraus resultierende flache Fortsätze der Leiterplatte verbindet und sich an diesen abstützt.

5. Datenlogger nach Anspruch 4, **dadurch gekennzeichnet, dass** eine von den flachen Fortsätzen eingeschlossene Stirnfläche des Ausschnitts in der Leiterplatte eine Anlagefläche für die Energiequelle, insbesondere eine Knopfzellenbatterie, bildet und wenigstens bereichsweise eine korrespondierend gekrümmte Kontur aufweist.

6. Datenlogger nach Anspruch 2 oder 3, **dadurch gekennzeichnet, dass** der Gehäusedeckel und das Aufnahmeteil jeweils als ein Stanzbiegeteil aus einem elektrisch leitenden Metallblech ausgebildet sind.

7. Datenlogger nach einem der Ansprüche 2 bis 6, **dadurch gekennzeichnet, dass** die innerhalb des Gehäuses angeordneten Funktionseinheiten eine Einheit für eine drahtlose Datenübermittlung umfassen.

8. Datenlogger nach Anspruch 7, **dadurch gekennzeichnet, dass** die Einheit für eine drahtlose Datenübermittlung eine elektromagnetische Strahlung emittierende Anzeigeeinrichtung umfasst, die von aussen sichtbar am bzw. innerhalb des Gehäuses montiert ist.

9. Datenlogger nach Anspruch 8, **dadurch gekennzeichnet, dass** die eine elektromagnetische Strahlung emittierende Anzeigeeinrichtung für eine Emission von Licht im sichtbaren Wellenlängenspektrum und/oder Infrarotstrahlung ausgebildet ist.

10. Datenlogger nach Anspruch 9, **dadurch gekennzeichnet, dass** die eine elektromagnetische Strahlung emittierende Anzeigeeinrichtung wenigstens eine Leuchtdiode umfasst, die vorzugsweise an der Leiterplatte angeordnet ist.

11. Datenlogger nach Anspruch 10, **dadurch gekennzeichnet, dass** in einer Deckfläche des Gehäusedeckels an einer Position, die zur Anordnung der wenigstens einen Leuchtdiode an der Leiterplatte korrespondiert, ein Fenster ausgespart ist.

12. Datenlogger nach Anspruch 11, **dadurch gekennzeichnet, dass** unterhalb des Fensters mehrere eng nebeneinander liegende Leuchdioden angeordnet sind.

13. Datenlogger nach Anspruch 11, **dadurch gekennzeichnet, dass** der Gehäusedeckel eine Anzahl von korrespondierenden Fenstern aufweist, die der Zahl von Leuchtdioden an der Leiterplatte entspricht.

14. Datenlogger nach einem der Ansprüche 2 bis 13, **dadurch gekennzeichnet, dass** in einer Deckfläche des Gehäusedeckels eine bewegliche Zunge ausgebildet ist, die mit einem Betätigungstaster zusammenwirkt, der auf der Leiterplatte angeordnet ist.

15. Datenlogger nach einem der Ansprüche 7 bis 14, **dadurch gekennzeichnet, dass** die Funktionseinheit zur Datenübermittlung für eine zeitlich und/oder intensitätsgesteuerte Modulation der elektromagnetische Strahlung emittierenden Anzeigeeinrichtung ausgebildet ist.

16. Datenlogger nach Anspruch 15, **dadurch gekennzeichnet, dass** die Funktionseinheit zur Datenübermittlung zur Ansteuerung der elektromagnetische Strahlung emittierenden Anzeigeeinrichtung mittels einer digitalen Phasenmodulation nach einem ein- oder mehrdimensionalen Manchester Code ausgebildet ist.

17. Datenlogger nach Anspruch 16, **dadurch gekennzeichnet, dass** die von der Funktionseinheit zur Datenübermittlung angesteuerte elektromagnetische Strahlung emittierende Anzeigeeinrichtung für eine unidirektionalen Kommunikation mit einem Smartphone, einem Tablet- oder Notebookcomputer ausgebildet ist, die eine Kamera zur Aufzeichnung von statischen und/oder dynamischen Lichtmustern aufweisen und mit einer Applikation zur Dekodierung und Weiterverarbeitung der von der elektromagnetische Strahlung emittierenden Anzeigeeinrichtung übermittelten Daten ausgestattet sind.

## Claims

1. Data loggers with functional units, arranged inside a housing, for acquiring, digitizing, optionally storing and optionally evaluating measurement data and for transmitting data to an external data processing device and with a power source, in particular a button cell battery, arranged inside the housing, wherein the functional units for acquiring, digitizing, optionally storing and optionally evaluating measurement data and for transmitting data to an external data processing device are arranged on a printed circuit board, which forms a component of the housing of the data logger, wherein the housing of the data logger at the same time forms the housing of the power source, and at least one electrical contact for the power source is made on the housing.

2. Data logger according to Claim 1, **characterized in that** the printed circuit board is equipped with at least one first electrical contact surface for the power source, while a second electrical contact for the power source is formed by an interior of a housing cover that faces the printed circuit board, which housing cover can be connected to the printed circuit board.

3. Data logger according to Claim 2, **characterized in that** the printed circuit board is provided with a recess, into which a holding part for the power source is inserted, which has the at least one first electrical contact for the power source and has an exterior that extends flush in a rear side of the printed circuit board and is aligned with the latter.

4. Data logger according to Claim 3, **characterized in that** the recess in the printed circuit board is designed as a flat cutaway, and the holding part connects two flat extensions of the printed circuit board resulting therefrom and is supported on the latter.

5. Data logger according to Claim 4, **characterized in that** a face of the cutaway in the printed circuit board encompassed by the flat extensions forms a support surface for the power source, in particular a button cell battery, and at least in places has a correspondingly curved contour.

6. Data logger according to Claim 2 or 3, **characterized in that** the housing cover and the holding part are in each case made as stamped bent parts from an electrically conductive metal sheet.

7. Data logger according to one of Claims 2 to 6, **characterized in that** the functional units that are arranged inside the housing comprise a unit for wireless data transmission.

8. Data logger according to Claim 7, **characterized in that** the unit for wireless data transmission comprises a display system that emits electromagnetic radiation, which system is visible from the outside or is mounted inside the housing.

9. Data logger according to Claim 8, **characterized in that** the display system that emits electromagnetic radiation is designed for an emission of light in the visible wavelength spectrum and/or infrared radiation.

10. Data logger according to Claim 9, **characterized in that** the display system that emits electromagnetic radiation comprises at least one light-emitting diode, which preferably is arranged on the printed circuit board.

11. Data logger according to Claim 10, **characterized in that** in a top surface of the housing cover, a window is recessed at a position that corresponds to the arrangement of the at least one light-emitting diode on the printed circuit board.

12. Data logger according to Claim 11, **characterized in that** multiple light-emitting diodes that lie closely beside one another are arranged below the window.

13. Data logger according to Claim 11, **characterized in that** the housing cover has a number of corresponding windows that corresponds to the number of light-emitting diodes on the printed circuit board.

14. Data logger according to one of Claims 2 to 13, **characterized in that** a movable tongue is made in a top surface of the housing cover, which tongue interacts with an actuating button, which is arranged on the printed circuit board.

15. Data logger according to one of Claims 7 to 14, **characterized in that** the functional unit for data transmission is designed for a time- and/or intensity-controlled modulation of the display system that emits electromagnetic radiation.

16. Data logger according to Claim 15, **characterized in that** the functional unit for data transmission is designed for controlling the display system that emits electromagnetic radiation by means of a digital phase modulation according to a one- or multi-dimensional Manchester Code.

17. Data logger according to Claim 16, **characterized in that** the display system that emits electromagnetic radiation controlled by the functional unit for data transmission is designed for unidirectional communication with a smartphone, a tablet- or notebook computer, which has a camera for recording static and/or dynamic light patterns and is equipped with an application for decoding and further processing of the data transmitted by the display system that emits electromagnetic radiation.

## Revendications

1. Enregistreur de données, comprenant des unités fonctionnelles qui sont disposées à l'intérieur d'un boîtier et sont destinées à la collecte, à la numérisation, le cas échéant à la sauvegarde et le cas échéant à l'évaluation de données de mesure et à la transmission de données à un appareil de traitement de données externe, et comprenant une source d'énergie, en particulier une pile-bouton, disposée à l'intérieur du boîtier, dans lequelles unités fonctionnelles, destinées à la collecte, à la numérisation, le cas échéant à la sauvegarde et le cas échéant à l'évaluation de données de mesure et à la transmission de données à un appareil de traitement de données externe, sont disposées sur une carte de circuit imprimé qui fait partie intégrante du boîtier de l'enregistreur de données, et dans lequelle boîtier de l'enregistreur de données constitue en même temps le boîtier de la source d'énergie, et au moins un contact électrique, destiné à la source d'énergie, est réalisé sur le boîtier.

2. Enregistreur de données selon la revendication 1, **caractérisé en ce que** la carte de circuit imprimé est dotée d'au moins une première surface de contact électrique pour la source d'énergie, tandis qu'un deuxième contact électrique pour la source d'énergie est formé par une face interne, tournée vers la carte de circuit imprimé, d'un couvercle de boîtier qui peut être relié à la carte de circuit imprimé.

3. Enregistreur de données selon la revendication 2, **caractérisé en ce que** la carte de circuit imprimé est pourvue d'un évidement dans lequel est placé un élément de réception pour la source d'énergie, qui présente le premier contact électrique, au nombre d'au moins un, pour la source d'énergie et possède une face externe qui se raccorde de manière affleurante à une face arrière de la carte de circuit imprimé et est alignée avec celle-ci.

4. Enregistreur de données selon la revendication 3, **caractérisé en ce que** l'évidement dans la carte de circuit imprimé est réalisé sous la forme d'une découpe de surface, et l'élément de réception relie deux prolongements plats de la carte de circuit imprimé qui en résultent et prend appui sur ceux-ci.

5. Enregistreur de données selon la revendication 4, **caractérisé en ce qu'**une face frontale de la partie découpée, qui est enfermée par les prolongements plats, forme dans la carte de circuit imprimé une surface d'appui pour la source d'énergie, en particulier une pile bouton, et présente, au moins par portions, un contour incurvé de façon correspondante.

6. Enregistreur de données selon la revendication 2 ou 3, **caractérisé en ce que** le couvercle de boîtier et l'élément de réception sont chacun réalisés comme pièce découpée et pliée à partir d'une tôle métallique électriquement conductrice.

7. Enregistreur de données selon l'une des revendications 2 à 6, **caractérisé en ce que** les unités fonctionnelles disposées à l'intérieur du boîtier comprennent une unité pour une transmission de données sans fil.

8. Enregistreur de données selon la revendication 7, **caractérisé en ce que** l'unité de transmission de données sans fil comprend un dispositif d'affichage émetteur de rayonnement électromagnétique, qui est monté sur ou dans le boîtier en étant visible de l'extérieur.

9. Enregistreur de données selon la revendication 8, **caractérisé en ce que** le dispositif d'affichage émetteur d'un rayonnement électromagnétique est conçu pour une émission de lumière dans le spectre visible des longueurs d'onde et/ou de rayonnement infrarouge.

10. Enregistreur de données selon la revendication 9, **caractérisé en ce que** le dispositif d'affichage émetteur d'un rayonnement électromagnétique comprend au moins une diode électroluminescente qui est disposée de préférence sur la carte de circuit imprimé.

11. Enregistreur de données selon la revendication 11, **caractérisé en ce qu'**une fenêtre est évidée dans une surface de dessus du couvercle de boîtier, à un emplacement qui correspond à la disposition de la diode électroluminescente, au nombre d'au moins une, sur la carte de circuit imprimé.

12. Enregistreur de données selon la revendication 11, **caractérisé en ce que** plusieurs diodes électroluminescentes, proches les unes des autres, sont disposées en dessous de la fenêtre.

13. Enregistreur de données selon la revendication 11, **caractérisé en ce que** le couvercle de boîtier présente un certain nombre de fenêtres correspondantes, qui correspond au nombre de diodes électroluminescentes sur la carte de circuit imprimé.

14. Enregistreur de données selon l'une des revendications 2 à 13, **caractérisé en ce qu'**il est prévu dans une surface de dessus du couvercle de boîtier, une languette mobile qui coopère avec un bouton-poussoir d'actionnement disposé sur la carte de circuit imprimé.

15. Enregistreur de données selon l'une des revendications 7 à 14, **caractérisé en ce que** l'unité fonctionnelle destinée à la transmission de données est conçue pour une modulation, avec un contrôle du temps et/ou de l'intensité, du dispositif d'affichage émetteur de rayonnement électromagnétique.

16. Enregistreur de données selon la revendication 15, **caractérisé en ce que** l'unité fonctionnelle destinée à la transmission de données est conçue pour activer le dispositif d'affichage émetteur de rayonnement électromagnétique, au moyen d'une modulation de phase numérique selon un code Manchester à une ou plusieurs dimensions.

17. Enregistreur de données selon la revendication 16, **caractérisé en ce que** le dispositif d'affichage émetteur de rayonnement électromagnétique, qui est activé par l'unité fonctionnelle destinée à la transmission de données, est conçu pour une communication unidirectionnelle avec un smartphone ou un ordinateur de type tablette ou portable, qui présentent une caméra destinée à enregistrer des motifs lumineux statiques et/ou dynamiques et sont dotés d'une application de décodage et de traitement ultérieur des données transmises par le dispositif d'affichage émetteur de rayonnement électromagnétique.
